# FASCICULE DE BREVET EUROPEEN

(11) **EP 4 414 721 B1**
(45) Date de publication et mention de la délivrance du brevet: **08.10.2025**
(21) Numéro de dépôt: 24156978.9
(22) Date de dépôt: 12.02.2024
(51) Int. Cl.: G01R 19/25, G01R 35/00, G01R 21/06, G01R 21/133, G01R 22/06, G01R 15/16

(54) **PROCÉDÉ ET SYSTÈME DE CALIBRATION DE MESURES DE TENSION DANS UN SYSTÈME DE MESURE DE GRANDEURS ÉLECTRIQUES**
VERFAHREN UND SYSTEM ZUR KALIBRIERUNG VON SPANNUNGSMESSUNGEN IN EINEM SYSTEM ZUR MESSUNG ELEKTRISCHER GRÖSSEN
METHOD AND SYSTEM FOR CALIBRATING VOLTAGE MEASUREMENTS IN A SYSTEM FOR MEASURING ELECTRICAL QUANTITIES

(30) Priorité: 13.02.2023 FR 2301318
(43) Date de publication de la demande: 14.08.2024
(73) Titulaire: SCHNEIDER ELECTRIC INDUSTRIES SAS, 92500 Rueil-Malmaison (FR)
(72) Inventeur: HENNEQUIN, Michel, 38920 CROLLES (FR); SICARD, Stephane, 38350 LA MURE (FR); BOHRER, Roland, 38134 LA SURE EN CHARTREUSE (FR); CAILLOU, Jonathan, 38500 LA BUISSE (FR); Leprettre, Benoit, 38700 LA TRONCHE (FR)
(74) Mandataire: Lavoix

(56) Documents cités:
- EP-A1- 3 671 231
- NL-B1- 2 016 237
- US-A1- 2013 069 627
- US-A1- 2013 211 751
- US-A1- 2015 369 848

## Description

La présente invention concerne un procédé et un système de calibration de mesures de tension dans un système de mesure de grandeurs électriques.

L'invention se situe dans le domaine de la mesure et du calcul de grandeurs électriques, de manière distribuée, dans une installation électrique.

En effet, dans des installations électriques, par exemple des réseaux locaux de distribution d'électricité, il est utile de mesurer des grandeurs électriques, en particulier le courant électrique, la tension, sur divers conducteurs électriques, dans plusieurs localisations du réseau, et de calculer d'autres grandeurs électriques, e.g. la puissance, l'énergie etc.

On connaît par exemple des dispositifs de mesure de grandeurs électriques, e.g. capteurs de courant ou de tension, qui ont des interfaces de communication, par exemple pour la communication des grandeurs électriques mesurées, ce qui permet mettre en oeuvre un réseau de communication entre des dispositifs de mesure vers un dispositif de communication passerelle, ce qui facilite la supervision et le contrôle du réseau électrique par des utilisateurs.

De plus, un calcul d'autres grandeurs électriques à partir des valeurs de courant et de tension mesurées par de tels capteurs peut être avantageusement réalisé dans un tel réseau de communication.

En particulier, l'invention s'applique dans le cas d'un système distribué de mesure de grandeurs électriques comportant une pluralité de dispositifs de mesure de grandeurs électriques munis de modules de mesure de tension par couplage capacitif. Dans un tel système, la mesure de tension par couplage capacitif, sans connexion directe au conducteur électrique concerné, est susceptible d'introduire un délai temporel. Or les signaux électriques alternatifs circulant dans une installation électrique sont chacun caractérisé par une amplitude et une phase. Un délai temporel se traduit par un décalage de phase ou déphasage dans les mesures de tension. Dans un système distribué de mesure de grandeurs électriques, les grandeurs électriques étant calculées pour des signaux de courant et de tension alternatifs, il est important de synchroniser temporellement les diverses mesures afin d'obtenir des calculs de grandeurs électriques, comme par exemple de puissance, de bonne précision. A cet effet, il est important de calibrer les mesures obtenues par les divers dispositifs de mesure de grandeurs électriques localisés dans divers endroits de l'installation électrique, la calibration concernant l'amplitude et/ou la phase des signaux électriques mesurés. Les dispositifs connus utilisés à cet effet sont présentés dans NL 2 016 237 B1, US 2013/211751 A1, US 2015/369848 A1, US 2013/069627 A1 ou EP 3 671 231 A1.

L'invention a pour objectif de proposer une solution de calibration des mesures de tension dans un tel système distribué de mesures de grandeurs électriques.

A cet effet, l'invention propose, selon un aspect, un système de calibration de mesures de tension dans un système de mesure de grandeurs électriques par une pluralité de dispositifs de mesure de grandeurs électriques distribués dans une installation électrique,
chaque dispositif de mesure de grandeurs électriques comportant
   - un module de mesure de tension par couplage capacitif,
   - une interface de communication configurée pour communiquer selon un protocole de communication,
   - une horloge locale permettant une datation d'évènements dans un référentiel temporel local,
le système comportant en outre un unique dispositif de calibration, configuré pour mesurer un signal de tension par contact avec un ou chaque conducteur électrique de l'installation électrique, le dispositif de calibration comportant une interface de communication configurée pour communiquer selon ledit protocole de communication et une horloge locale.

Ce système comporte en outre un dispositif de synchronisation comportant une horloge dite de synchronisation, permettant une datation d'évènement dans un référentiel temporel de référence, lesdits dispositifs de mesure de grandeurs électriques et le dispositif de calibration étant chacun configuré communiquer avec le dispositif de synchronisation et pour mettre en oeuvre un mécanisme de synchronisation de l'horloge locale avec l'horloge de synchronisation, permettant une datation d'évènement dans ledit référentiel temporel de référence. Le dispositif de calibration est configuré pour :
déterminer un premier instant temporel de référence, dans le référentiel temporel de référence, d'un évènement de passage par zéro dudit signal de tension mesuré par le dispositif de calibration,
émettre un message de calibration comprenant ledit premier instant temporel de référence et une valeur d'amplitude de tension mesurée vers au moins un dispositif mesure grandeurs électriques et,
ledit au moins un dispositif de mesure grandeurs électriques est configuré pour :
recevoir ledit message de calibration en provenance du dispositif de calibration, et extraire ledit premier instant temporel de référence et l'amplitude de tension,
déterminer un deuxième instant temporel de passage à zéro du signal de tension mesuré localement, dans le référentiel temporel de référence, dit deuxième instant temporel de référence, correspondant audit premier instant de référence,
calculer un décalage de phase du signal de tension mesuré localement, en fonction de la différence entre le premier instant temporel de référence et le deuxième instant temporel de référence,
appliquer une calibration de tension en phase et en amplitude en fonction de l'amplitude de tension reçue et du décalage de phase calculé.

Avantageusement, le système de calibration proposé permet un calcul de déphasage pour chaque dispositif de mesure de grandeurs électriques.

Le système de calibration de mesures de tension distribuées selon l'invention peut présenter une ou plusieurs des caractéristiques ci-dessous, prises indépendamment ou selon toutes les combinaisons acceptables.

Le dispositif de mesure grandeurs électriques est configuré pour mémoriser une pluralité de deuxièmes instants temporels, exprimés dans le référentiel de référence, de passage à zéro du signal de tension mesuré localement.

Pour la détermination du deuxième instant temporel de référence, ledit dispositif de mesure grandeurs électriques est configuré pour déterminer parmi les deuxièmes instants temporels mémorisés, le deuxième instant temporel de passage à zéro le plus proche dudit premier instant temporel de référence.

Le dispositif de calibration est configuré pour diffuser ledit message de calibration à tous les dispositifs de mesure de grandeurs électriques.

Le protocole de communication est le protocole ZigBee Green Power.

Le dispositif de synchronisation est configuré pour envoyer successivement des messages de synchronisation vers au moins un dispositif communicant parmi les dispositifs de mesure de grandeurs électriques et ledit dispositif de calibration, les messages de synchronisation successifs comportant au moins un message de synchronisation courant et un message de synchronisation précédent, le message de synchronisation courant contenant un identifiant incrémental de message de synchronisation et un instant temporel d'envoi du message de synchronisation précédent, chaque dispositif communicant récepteur desdits messages de synchronisation étant configuré pour mémoriser une table de synchronisation locale, mémorisant des informations relatives à des instants temporels, dans le référentiel temporel local, de réception de messages du dispositif de synchronisation et les instants temporels d'envoi desdits messages de synchronisation, dans le référentiel temporel de référence, par le dispositif de synchronisation.

Chaque dispositif communicant est configuré pour calculer une correspondance entre l'horloge locale dudit dispositif communicant et l'horloge de référence en utilisant la table de synchronisation locale.

Le dispositif de synchronisation est un dispositif de communication passerelle, comportant une interface de communication configurée pour communiquer selon ledit protocole de communication.

Selon un autre aspect, l'invention concerne un procédé de calibration de mesures de tension mis en oeuvre dans un système de calibration tel que décrit ci-dessus, comportant des étapes :
- par le dispositif de calibration:
   - déterminer un premier instant temporel de référence, dans le référentiel temporel de référence, d'un évènement de passage par zéro dudit signal de tension mesuré par le dispositif de calibration,
   - émettre un message de calibration comprenant ledit premier instant temporel de référence et une valeur d'amplitude de tension mesurée vers au moins un dispositif mesure grandeurs électriques,
   - par au moins un dispositif de mesure de grandeurs électriques :
      recevoir ledit message de calibration en provenance du dispositif de calibration, et extraire ledit premier instant temporel de référence et l'amplitude de tension,
      déterminer un deuxième instant temporel de passage à zéro du signal de tension mesuré localement, dans le référentiel temporel de référence, dit deuxième instant temporel de référence, correspondant audit premier instant de référence,
      calculer un décalage de phase du signal de tension mesuré localement, en fonction de la différence entre le premier instant temporel de référence et le deuxième instant temporel de référence,
      appliquer une calibration de tension en phase et en amplitude en fonction de l'amplitude de tension reçue et du décalage de phase calculé.

Ce procédé comporte les mêmes avantages que ceux du système de calibration.

Le procédé de calibration de mesures de tension distribuées selon l'invention peut présenter une ou plusieurs des caractéristiques ci-dessous, prises indépendamment ou selon toutes les combinaisons acceptables. Le mécanisme de synchronisation comporte, par le dispositif de synchronisation, un envoi de messages de synchronisation successifs à au moins un dispositif communicant parmi les dispositifs de mesure de grandeurs électriques et le dispositif de calibration, les messages successifs comportant au moins un message de synchronisation courant et un message de synchronisation précédent, le message de synchronisation courant comprenant un identifiant incrémental de message de synchronisation et un instant temporel d'envoi du message précédent.

Les messages de calibration et de synchronisation sont envoyés par ledit dispositif de synchronisation, regroupés en des messages de calibration et synchronisation, à destination desdits dispositifs de mesure de grandeurs électriques.

D'autres caractéristiques et avantages de l'invention ressortiront de la description qui en est donnée ci-dessous, à titre indicatif et nullement limitatif, en référence aux figures annexées, parmi lesquelles :
[Fig 1] la figure 1 représente schématiquement un système distribué de mesures de grandeurs électriques dans une installation électrique ;
[Fig 2] la figure 2 est un graphique illustrant deux courbes représentatives de signaux de tension et le décalage de phase entre ces deux courbes ;
[Fig 3] la figure 3 représente schématiquement un procédé de synchronisation entre un dispositif communicant et le dispositif de synchronisation dans un mode de réalisation ;
[Fig 4] la figure 4 représente les principales étapes d'un procédé de calibration selon un mode de réalisation.

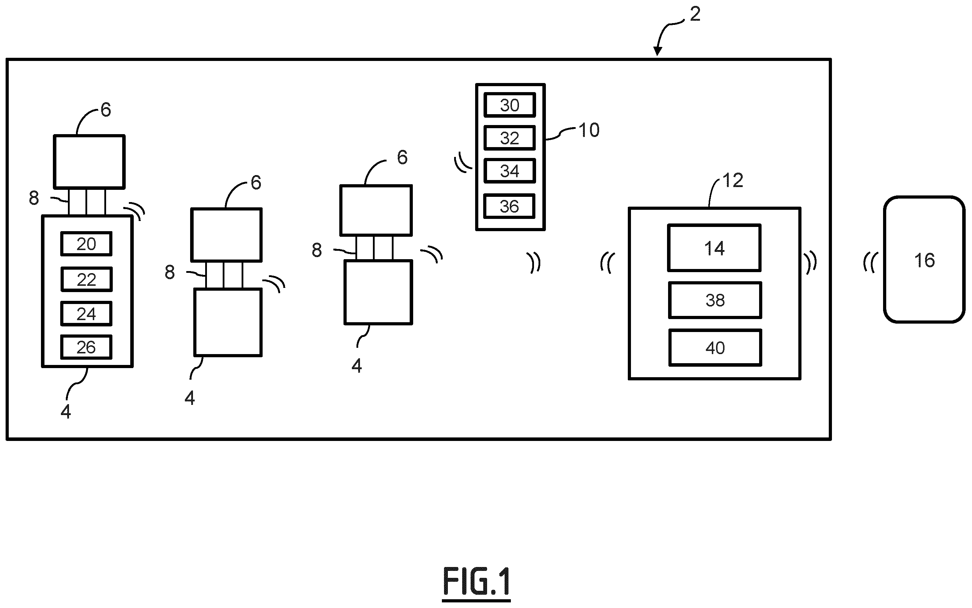

L'invention s'applique notamment dans un système de mesure de grandeurs électriques dans une installation électrique tel que décrit dans la figure 1.

Il est à noter que l'invention s'applique plus généralement pour la calibration de mesures de tension dans une installation électrique, fournies par une pluralité de dispositifs de mesure munis de modules de mesure de tension par couplage capacitif, induisant un retard de mesure qui se traduit par un déphasage.

La figure 1 illustre schématiquement un système de mesure de grandeurs électriques 2, les mesures étant effectuées de manière distribuée, dans une installation électrique.

L'installation électrique, qui n'est pas représentée dans la figure 1, est par exemple une installation domestique de distribution d'électricité ou une installation de distribution d'électricité de bâtiment commercial, industriel ou tertiaire, configurée pour fournir une énergie électrique et des charges consommatrices d'énergie électrique (non représentées), connectées au moyen de conducteurs électriques 8, à partir d'une ou plusieurs sources d'énergie électrique, comprenant notamment un réseau public de distribution d'électricité fournissant un courant alternatif, et, optionnellement, des sources locales e.g. des panneaux photovoltaïques.

Les conducteurs électriques 8 sont par exemple des câbles ou barres conductrices en matériau électriquement conducteur.

L'installation électrique peut être une installation monophasée ou polyphasée, comportant un nombre N de phases de courant électrique, avec ou sans conducteur de neutre.

Dans la représentation schématique de la figure 1, le système 2 de mesures de grandeurs électriques comporte une pluralité de dispositifs 4 de mesure de grandeurs électriques, par exemple jusqu'à 40 dispositifs de mesure.

Chaque dispositif 4 de mesure de grandeurs électriques est connecté, dans l'exemple illustré, à un appareil de protection électrique 6, par exemple un disjoncteur, au moyen de conducteur électriques 8.

Par exemple, dans un mode de réalisation, l'ensemble des disjoncteurs 6 et des dispositifs 4 de mesure de grandeurs électriques est placé dans un tableau électrique ou dans une armoire électrique.

En variante, chaque dispositif 4 de mesure de grandeurs électriques est connecté sur un point du réseau électrique à surveiller, sans connexion à un appareil de protection électrique.

Chaque dispositif 4 est muni d'une interface de communication sans fil. En d'autres termes, chaque dispositif 4 est un dispositif communicant, configuré pour communiquer selon un protocole sans fil choisi, avec les autres dispositifs communicants du système 2 de calcul de grandeurs électriques, formant ainsi un réseau de communication local d'objets connectés.

Par exemple, le protocole de communication sans fil mis en oeuvre est le protocole Bluetooth^{®}, ou le protocole Zigbee Green Power ^{®}.

Comme décrit plus en détail par la suite, chaque dispositif 4 est configuré pour réaliser des mesures de grandeurs électriques caractérisant le signal électrique qui circule dans le ou dans chaque conducteur électrique 8 de l'installation électrique à surveiller.

En particulier, chaque dispositif 4 est configuré pour fournir des mesures de tension par couplage capacitif, i.e. sans contact avec le conducteur électrique 8.

Ainsi, chaque dispositif 4 est un dispositif de mesure de tension par couplage capacitif.

Dans un mode de réalisation, chaque dispositif 4 est en outre configuré pour fournir des mesures de courant électrique en continu sur le ou sur chacun des conducteurs électriques 8 auquel il est connecté. En d'autres termes, dans ce mode de réalisation, chaque dispositif 4 est configuré pour mesurer le courant et la tension.

En plus, chaque dispositif 4 comporte un circuit électronique programmable, e.g. un processeur, un microprocesseur, un circuit électronique forme de composants logiques programmables, tels que des FPGA (de l'anglais *Field Programmable Gate Array),* ou encore de circuits intégrés dédiés, tels que des ASIC (de l'anglais *Application Specific Integrated Circuit),* configuré pour réaliser des calculs de grandeurs électriques choisies.

Le système 2 comporte en outre, dans un mode de réalisation, un seul dispositif 10 de mesure de tension, appelé dispositif de calibration, configuré pour réaliser une mesure de tension par contact, muni d'une interface de communication, de manière à permettre la diffusion (en anglais « broadcast ») des mesures de tension réalisées en continu aux dispositifs 4 de mesure de grandeurs électriques, ce qui permet d'améliorer la précision des mesures de tension dans le système.

Le système 2 comprend en outre, dans ce mode de réalisation, un dispositif de communication passerelle 12 (« gateway » en anglais), comportant une interface de communication 14 configurée pour communiquer selon le protocole de communication utilisé par les dispositifs 4, de manière à réaliser une communication bidirectionnelle avec ces dispositifs 4.

En outre, le dispositif de communication passerelle 12 est configuré pour communiquer, par exemple selon le même ou un autre protocole de communication sans fil, avec un ou plusieurs dispositifs utilisateur 16. Par exemple cet autre protocole de communication sans fil est le protocole Wifi ou Bluetooth^{®}.

Selon une variante, une communication filaire est utilisée, par exemple en utilisant le protocole Ethernet ou ModBus.

Ainsi, un utilisateur, par exemple un opérateur de maintenance, est capable de recevoir, via le dispositif utilisateur 16, des mesures de grandeurs électriques obtenues, permettant la supervision, la surveillance de bon fonctionnement, la planification de la maintenance prédictive de l'installation électrique concernée.

Les mesures fournies sont par exemple affichées sur une interface homme-machine du dispositif utilisateur 16.

Les dispositifs 4 de mesure de grandeurs électriques ont des structures similaires, un dispositif 4 de mesure de grandeurs électriques est décrit plus en détail en référence à la figure 1, étant entendu que les autres dispositifs 4 sont similaires.

Le dispositif 4 comporte une interface de communication 20, configurée pour communiquer selon le protocole de communication choisi avec les autres dispositifs 4 et avec le dispositif de communication passerelle 12.

Le dispositif 4 comporte un module 22 de mesure de tension par couplage capacitif.

Plusieurs agencements d'un tel module de la tension par couplage capacitif sont envisageables et à la portée de l'homme du métier.

Ainsi, le dispositif 4 est un dispositif de mesure de tension configuré pour effectuer une mesure de tension par couplage capacitif.

De plus le dispositif 4 comporte un processeur de calcul 24 et une horloge 26 associée, dite horloge locale. Une datation d'un évènement en utilisant l'horloge locale du dispositif 4 est appelée datation dans le référentiel temporel local.

Ainsi, chaque dispositif 4 a un référentiel temporel local associé.

Le dispositif de calibration 10 comporte une interface de communication 30, configurée pour communiquer selon le protocole de communication sans fil avec les autres dispositifs 4 et avec le dispositif de communication passerelle 12 et un module 32 de mesure de tension avec connexion au conducteur électrique 8 correspondant. Avantageusement, le module 32 de mesure de tension fournit une mesure de tension précise en amplitude et en phase.

Le dispositif de calibration 10 comporte en outre un microprocesseur de calcul 34, ou un autre type de processeur, un circuit électronique forme de composants logiques programmables, tels que des FPGA (de l'anglais *Field Programmable Gate Array),* ou encore de circuits intégrés dédiés, tels que des ASIC (de l'anglais *Application Specific Integrated Circuit),* et une horloge locale 36 associée, qui permet une datation dans un référentiel temporel dit de calibration.

Le dispositif de communication passerelle 12 comporte également un processeur de calcul 38 et une horloge 40, qui est une horloge interne de ce dispositif, par exemple associée au processeur de calcul 38.

Un des dispositifs communicants 4, 10, 12 est sélectionné pour remplir la fonction de dispositif de synchronisation, qui fournit un référentiel temporel commun, dit référentiel temporel de référence.

En d'autres termes, le dispositif de synchronisation est le dispositif maître de la synchronisation temporelle, et les autres dispositifs communicants du réseau sont des dispositifs esclaves.

Dans un mode de réalisation, le dispositif de communication passerelle 12 est choisi comme dispositif de synchronisation, l'horloge de ce dispositif étant alors dite horloge de synchronisation, le référentiel temporel du dispositif de communication passerelle 12 étant alors le référentiel temporel de synchronisation.

Avantageusement, le dispositif de communication passerelle 12 est configuré pour communiquer avec tous les autres dispositifs communicants du système. En particulier, lorsque le protocole de communication utilisé est le protocole ZigBee Green Power, toutes les communications entre dispositifs communicants passent par le dispositif de communication passerelle, donc il est avantageux de sélectionner le dispositif passerelle 12 comme dispositif de synchronisation.

En variante, lorsque le protocole de communication est un autre protocole de communication que le protocole ZigBee Green Power, par exemple le protocole Bluetooth ou le protocole ZigBee Pro, un autre des dispositifs communicants, par exemple le dispositif de calibration 10 ou un des dispositifs de mesure de grandeurs électriques 4 est choisi comme dispositif de synchronisation.

Un mécanisme de synchronisation est mis en oeuvre par le dispositif de synchronisation et les autres dispositifs communicants du système, permettant à chaque dispositif communicant de dater des évènements dans le référentiel temporel de référence.

Les dispositifs communicants sont adaptés pour recevoir des messages de synchronisation du dispositif de synchronisation, contenant une information dite de synchronisation relative à l'horloge de synchronisation. Grâce à cette communication, reçue par chacun des dispositifs communicants met en œuvre un calcul de décalage temporel entre son horloge locale et l'horloge de synchronisation, et par conséquent, pour chaque instant temporel local, un instant temporel de référence correspondant.

Par exemple, chaque message de synchronisation contient un numéro d'identifiant et une information temporelle, comme expliqué plus en détail ci-après.

Dans un mode de réalisation, le message de synchronisation est diffusé (en anglais « broadcast ») en même temps à tous les dispositifs communicants du réseau. Ainsi, les dispositifs communicants récepteurs reçoivent le message de synchronisation.

Dans un autre mode de réalisation, en particulier lorsque le protocole de communication est le protocole ZigBee GreenPower, le message de synchronisation est envoyé à chaque dispositif communicant en réponse à un message du dispositif communicant à destination du dispositif de communication passerelle.

Le mécanisme de synchronisation corrige le décalage et la dérive entre l'horloge locale et l'horloge de synchronisation, et permet à chaque dispositif communicant de dater un évènement dans le référentiel temporel de référence.

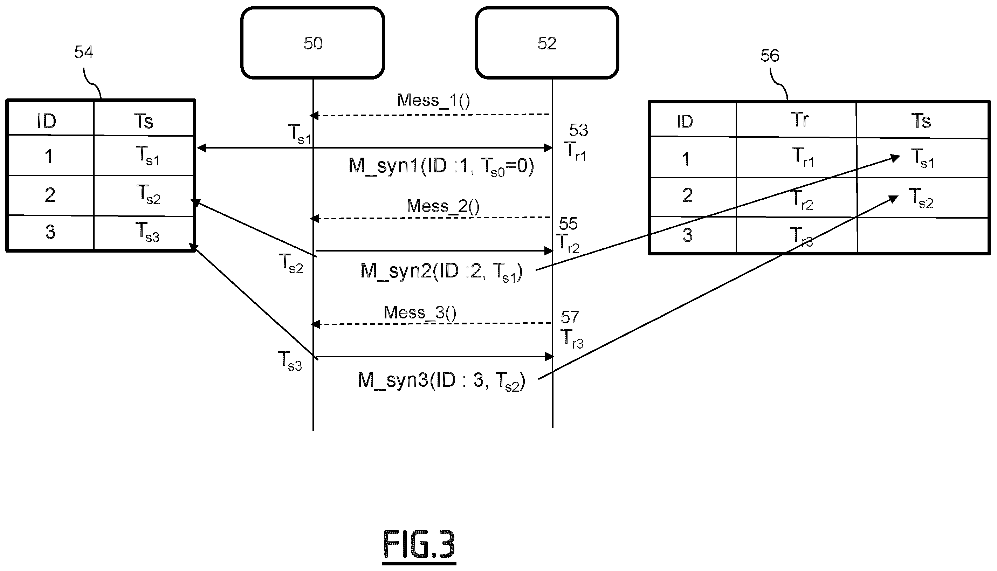

Un mode de réalisation du mécanisme de synchronisation sera décrit ci-après en référence à la figure 3.

La calibration des mesures de tension est alors effectuée dans ce système 2, pour permettre une calibration en amplitude et en phase, le signal de tension étant un signal alternatif.

Le dispositif de calibration 10, qui effectue des mesures précises, est configuré pour diffuser dans des messages de diffusion (« broadcast ») ou dans des messages destinés à chaque dispositif 4, , d'une part l'amplitude de tension mesurée, et d'autre par un instant temporel de passage à zéro (en anglais « zero-crossing ») du signal de tension mesuré par le dispositif de calibration, l'instant temporel étant exprimé dans le référentiel temporel de référence. Ces messages destinés à la calibration sont envoyés régulièrement, à cadence donnée, par exemple toutes les 5 secondes, et plus généralement à une cadence comprise entre 1seconde et 30 secondes.
- Plus précisément, le dispositif de calibration 10 est configuré pour, lors de chaque évènement Ei de passage à zéro du signal de tension mesuré : déterminer un premier instant temporel de référence T-ref_{i,1}, dans le référentiel temporel de référence, de l'évènement Ei de passage par zéro du signal de tension mesuré,
- émettre un message de calibration comportant le premier instant temporel de référence T-ref_{i,1} ainsi qu'une valeur d'amplitude de tension mesurée vers au moins un dispositif 4 de mesure de tension par couplage capacitif.

Chaque dispositif 4 est configuré pour déterminer des instants temporels de passage à zéro du signal de tension mesuré localement, dans le référentiel temporel local, puis dans le référentiel temporel de référence, et pour:
- recevoir le message de calibration en provenance du dispositif de calibration, et extraire ledit premier instant temporel de référence et l'amplitude de tension,
- déterminer un deuxième instant temporel de passage à zéro du signal de tension mesuré localement, dans le référentiel temporel de référence, dit instant temporel de référence, correspondant au premier instant de référence,
- calculer un décalage de phase du signal de tension mesuré localement, en fonction de la différence entre le premier instant temporel de référence et le deuxième instant temporel de référence,
- appliquer une calibration de tension en phase et en amplitude de tension en fonction de l'amplitude de tension reçue et du décalage de phase calculé.

Dans un mode de réalisation, pour déterminer le deuxième instant temporel correspondant au premier instant temporel, i, recherche est effectuée parmi des instants temporels, dans le référentiel temporel de référence, de passage à zéro du signal de tension mesuré localement, par exemple dans une fourchette de +/- 1ms, et c'est l'instant temporel le plus proche du premier instant temporel reçu qui est sélectionné.

Le décalage de phase estimé est un décalage temporel entre le premier et le deuxième instant temporel de référence correspondant à un même évènement de passage à zéro de la mesure de tension.

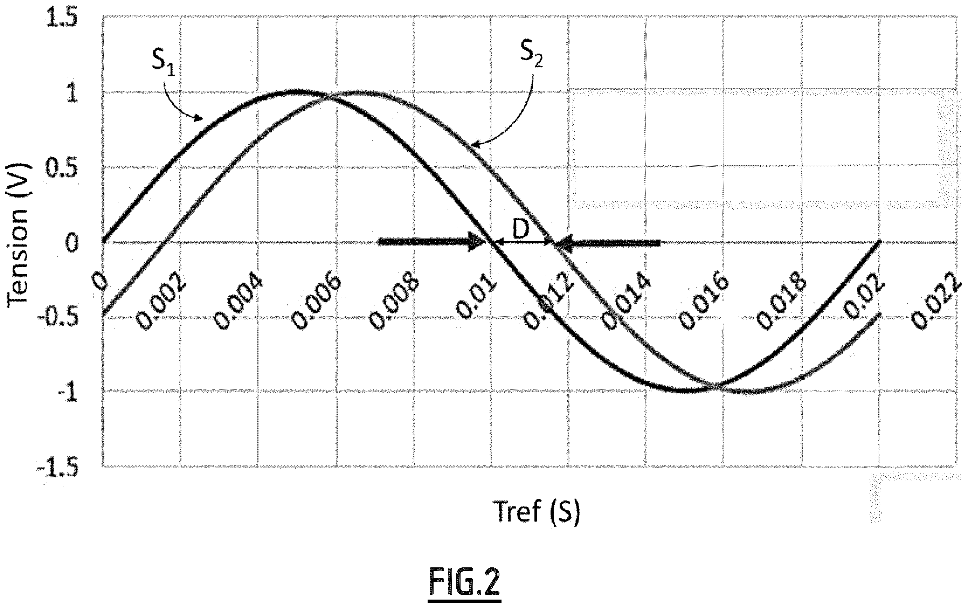

La figure 2 illustre graphiquement deux courbes S₁ et S₂ dans un graphe représentant la tension (en ordonnée) en fonction du temps dans le référentiel temporel de référence (en abscisse), la courbe S₁ représentant la mesure de tension par le dispositif de calibration 10 et la courbe S₂ représentant la mesure de tension par un module de tension d'un dispositif de mesure 4.

Le décalage D est visible sur ce graphe.

En référence à la figure 3 est décrit un procédé de synchronisation dans le cas où le protocole de communication utilisé par les dispositifs communicants 4, 10 et 12 est le protocole ZigBee Green Power.

Dans ce mode de réalisation, le dispositif de synchronisation est le dispositif de communication passerelle 12.

Une particularité de ce protocole de communication est que les communications avec le dispositif de communication passerelle 12 doivent être initiées par les autres dispositifs communicants du réseau de communication.

La figure 3 illustre schématiquement le mécanisme de synchronisation entre le dispositif de synchronisation 50 (e.g. le dispositif de communication passerelle 12) et un des dispositifs communicants, référencé 52 dans la figure 3, pouvant être un des dispositifs 4 ou le dispositif 10.

Le dispositif de synchronisation 50 maintient une table de synchronisation temporelle 54 pour chaque dispositif communicant 52, mémorisée dans une mémoire électronique du dispositif de synchronisation 50.

Le dispositif communicant 52 maintient également, dans une mémoire électronique, une table de synchronisation temporelle locale 56.

L'exemple de la figure 2 illustre 3 communications successives respectivement référencées 53, 55, 57.

Dans ce mode de réalisation le dispositif communicant 52 envoie successivement des messages Mess_1, Mess_2, Mess_3, dont le contenu est libre, au dispositif de synchronisation 50.

Le dispositif de synchronisation envoie successivement, en réponse aux messages Mess 1_, Mess_2, Mess_3 ou à des intervalles réguliers, des messages de synchronisation M-syn1, M-syn2, Mess-syn3.

Chaque message de synchronisation contient un numéro d'identification incrémental, par exemple incrémenté de 1 à chaque envoi à partir de ID=1 dans cet exemple, et une information temporelle qui est l'instant d'envoi d'un précédent message de synchronisation au dispositif communicant 52.

A l'initialisation, l'instant d'envoi du message précédent est initialisé à une valeur prédéterminé, par exemple à 0.

Le dispositif de synchronisation 50 met en œuvre une mémorisation dans la table de synchronisation temporelle 54 des instants temporels d'envoi des messages de synchronisation, et des identifiants incrémentaux associés. Les instants temporels d'envoi sont exprimés dans le référentiel temporel de référence.

Le dispositif communicant 52 reçoit, à des instants temporels de réception, dans le référentiel temporel local, notés Tᵣᵢ, les message de synchronisation en provenance du dispositif de synchronisation 50.

Le dispositif communicant 52 mémorise les informations d'identifiant de message et l'instant temporel de réception Tᵣᵢ dans la table de synchronisation temporelle locale 56, ainsi que les instants temporels d'envoi de message précédent reçus du dispositif de synchronisation.

Le mécanisme est répété de manière analogue lors de plusieurs étapes de communication 53, 55, 57 successives, ce qui permet de mémoriser plusieurs informations temporelles relatives à des instants temporels d'envoi de messages de synchronisation, dans le référentiel temporel de référence Tₛ₁, Tₛ₂, Tₛ₃, dans la table de synchronisation temporelle locale 56.

Il est possible d'obtenir l'instant temporel correspondant T_{ref-k} dans le référentiel temporel de référence pour un instant temporel T_{I-k} dans le référentiel temporel local, à partir de la table de synchronisation temporelle locale 56, il est possible d'obtenir l'instant temporel correspondant T_{ref-k} dans le référentiel temporel de référence.

Bien entendu, le procédé expliqué en référence à la figure 3 pour un dispositif communicant est appliqué pour chacun des dispositifs communicants, i.e. pour le dispositif de calibration 10 et pour chacun des dispositifs 4 de mesure de grandeurs électriques.

Il est à noter que dans d'autres modes de réalisation, par exemple lorsqu'un autre protocole de communication que le protocole ZigBee Green Power est utilisé, les messages Mess_1, Mess_2, Mess_3 ne sont pas envoyés.

Le dispositif de synchronisation transmet, à intervalles temporels réguliers, des messages de synchronisation, comportant un identifiant incrémental et un instant temporel d'envoi, comme expliqué ci-dessus. Ces messages de synchronisation sont utilisés, de manière analogue à ce qui est décrit ci-dessus, par chaque dispositif communicant, pour obtenir une correspondance entre l'horloge locale du dispositif communicant et l'horloge de référence.

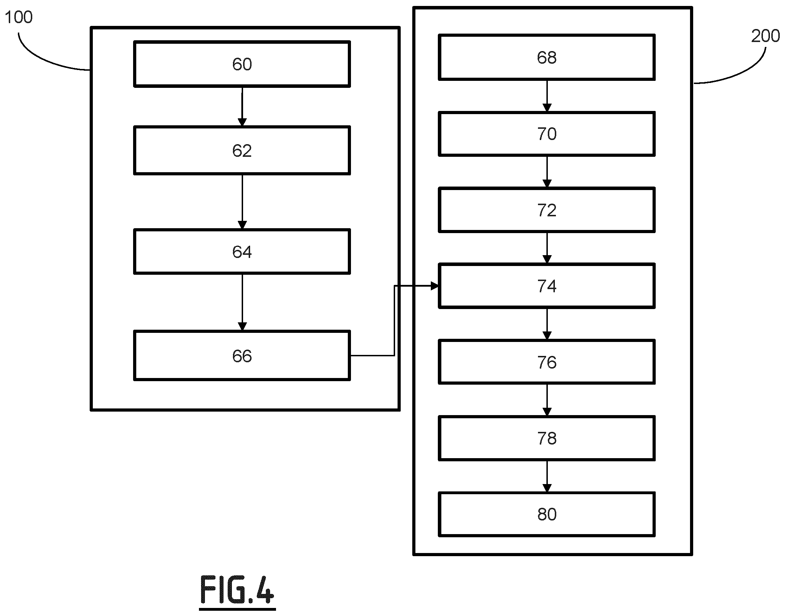

La figure 4 est un synoptique des principales étapes d'un mode de réalisation du procédé de calibration de mesures de tension, comportant un ensemble d'étapes 100 mises en oeuvre par le processeur du dispositif de calibration et un ensemble d'étapes 200 mises en oeuvre respectivement par le processeur d'un dispositif de mesure de grandeurs électriques.

Le procédé comporte, pour un signal de tension alternatif, une étape 60 de détection d'un évènement de passage à zéro Ek, mise en œuvre par le dispositif de calibration 10, et une datation (étape 62) dans le référentiel temporel local du dispositif de calibration, noté Tmₖ.

Dans des modes de réalisation, la détection 60 et la datation 62 sont effectuées en une seule étape.

Le procédé comporte en outre, par le dispositif de calibration, une étape 64 de détermination d'un premier instant temporel de référence T-ref_{k,1}, dans le référentiel temporel de référence, correspondant à l'instant temporel de calibration Tmₖ, en utilisant le mécanisme de synchronisation décrit ci-dessus.

Le procédé comporte en outre une émission 66 d'un message de calibration comprenant le premier instant temporel de référence T-ref_{k,1} et une valeur d'amplitude de tension mesurée par le dispositif de calibration vers au moins un dispositif mesure grandeurs électriques.

La valeur d'amplitude de tension mesurée est par exemple une valeur efficace de la tension alternative mesurée, également appelée valeur quadratique moyenne (en anglais RMS pour « root mean square ») de la tension alternative mesurée.

Le dispositif 4 de mesure de grandeurs électriques met en œuvre une étape 68 de de détection d'un ou plusieurs évènements de passage à zéro Ej du signal de tension mesuré localement, de datation du ou des évènements de passage à zéro dans le référentiel temporel local (étape 70), puis de calcul d'instants temporels de passage à zéro correspondants, dits deuxièmes instants temporels, dans le référentiel temporel de référence (étape 72) en mettant en œuvre le mécanisme de synchronisation.

Dans un mode de réalisation, plusieurs instants temporels Tⱼ successifs de passage à zéro du signal de tension mesuré localement sont mémorisés à l'étape 72 également.

Le dispositif 4 reçoit, lors d'une étape 74 de réception, le message de calibration et en extrait le premier instant temporel de référence calculé par le dispositif de calibration 10 et l'amplitude de tension transmise.

Ensuite, le dispositif 4 met en œuvre une étape 76 détermination d'un deuxième instant temporel de passage à zéro du signal de tension mesuré localement, dans le référentiel temporel de référence, dit deuxième instant temporel de référence T-ref_{k,2}, correspondant audit premier instant de référence T-ref_{k,1}.

Dans un mode de réalisation, le deuxième instant temporel de référence T-ref_{k,2} est l'instant temporel de passage à zéro le plus proche, parmi les instants temporel Tⱼ mémorisés, du premier instant temporel de référence T-ref_{k,1}. Par exemple, le deuxième instant temporel de référence T-ref_{k,2} est décalé de moins d'une milliseconde du premier instant temporel de référence T-ref_{k,1}.

Le procédé comporte en outre une étape 78 de calcul de décalage de phase D, en fonction de la différence entre le premier instant temporel de référence T-ref_{k,1} et le deuxième instant temporel de référence T-ref_{k,2}.

Le décalage de phase D calculé est appliqué à l'étape de calibration 80 ensuite pour calibrer, i.e. recaler temporellement, les mesures de tension par rapport à des mesures de courant obtenues par ailleurs, ce qui permet ensuite un calcul de puissances de précision.

L'amplitude de tension reçue dans le message de calibration est également utilisée à l'étape de calibration 80 pour calibrer l'amplitude du signal de tension mesuré localement.

Les étapes décrites ci-dessus sont répétées à des intervalles temporels réguliers, par exemple toutes les 1 à 30 secondes, par exemple toutes les 5 secondes,
Dans un mode de réalisation, les messages de synchronisation passent également par le dispositif passerelle, qui les transmet aux dispositifs 4 de mesure de grandeurs électriques.

Avantageusement, il est prévu, dans un mode de réalisation, de regrouper les informations de calibration et de synchronisation à destination des dispositifs 4 de mesure de grandeurs électriques, dans des messages de synchronisation et de calibration, ce qui permet de réduire le nombre de messages échangés, donc de réduire le trafic et la consommation d'énergie des modules de communication des dispositifs communicants.

## Revendications

1. Système de calibration de mesures de tension dans un système de mesure de grandeurs électriques par une pluralité de dispositifs de mesure de grandeurs électriques distribués dans une installation électrique,
chaque dispositif de mesure de grandeurs électriques (4)comportant
- un module de mesure de tension (22) par couplage capacitif,
- une interface de communication (20) configurée pour communiquer selon un protocole de communication,
- une horloge locale (26) permettant une datation d'évènements dans un référentiel temporel local,
le système comportant en outre un unique dispositif de calibration (10), configuré pour mesurer (32) un signal de tension par contact avec un ou chaque conducteur électrique de l'installation électrique, le dispositif de calibration (10) comportant une interface de communication (30) configurée pour communiquer selon ledit protocole de communication et une horloge locale (36),
le système **caractérisé en ce qu'**il comporte en outre un dispositif de synchronisation comportant une horloge dite de synchronisation, permettant une datation d'évènement dans un référentiel temporel de référence,
lesdits dispositifs de mesure de grandeurs électriques (4) et le dispositif de calibration (10) étant chacun configuré communiquer avec le dispositif de synchronisation et pour mettre en œuvre un mécanisme de synchronisation de l'horloge locale avec l'horloge de synchronisation, permettant une datation d'évènement dans ledit référentiel temporel de référence, et **en ce que** :
le dispositif de calibration (10) est configuré pour :
déterminer un premier instant temporel de référence, dans le référentiel temporel de référence, d'un évènement de passage par zéro dudit signal de tension mesuré par le dispositif de calibration,
émettre un message de calibration comprenant ledit premier instant temporel de référence et une valeur d'amplitude de tension mesurée vers au moins un dispositif mesure grandeurs électriques (4) et,
ledit au moins un dispositif de mesure grandeurs électriques (4) est configuré pour :
recevoir ledit message de calibration en provenance du dispositif de calibration, et extraire ledit premier instant temporel de référence et l'amplitude de tension,
déterminer un deuxième instant temporel de passage à zéro du signal de tension mesuré localement, dans le référentiel temporel de référence, dit deuxième instant temporel de référence, correspondant audit premier instant de référence,
calculer un décalage de phase du signal de tension mesuré localement, en fonction de la différence entre le premier instant temporel de référence et le deuxième instant temporel de référence,
appliquer une calibration de tension en phase et en amplitude en fonction de l'amplitude de tension reçue et du décalage de phase calculé.

2. Système selon la revendication 1, dans lequel ledit dispositif de mesure grandeurs électriques (4) est configuré pour mémoriser une pluralité de deuxièmes instants temporels, exprimés dans le référentiel de référence, de passage à zéro du signal de tension mesuré localement.

3. Système selon la revendication 2, dans lequel pour la détermination du deuxième instant temporel de référence, ledit dispositif de mesure grandeurs électriques (4) est configuré pour déterminer parmi les deuxièmes instants temporels mémorisés, le deuxième instant temporel de passage à zéro le plus proche dudit premier instant temporel de référence.

4. Système selon l'une des revendications 1 à 3 dans lequel ledit dispositif de calibration (10) est configuré pour diffuser ledit message de calibration à tous les dispositifs de mesure de grandeurs électriques.

5. Système selon l'une des revendications 1 à 4, dans lequel ledit protocole de communication est le protocole ZigBee Green Power.

6. Système selon l'une quelconque des revendications 1 à 5, dans lequel le dispositif de synchronisation (12) est configuré pour envoyer successivement des messages de synchronisation vers au moins un dispositif communicant parmi les dispositifs de mesure de grandeurs électriques (4) et ledit dispositif de calibration (10), les messages de synchronisation successifs comportant au moins un message de synchronisation courant et un message de synchronisation précédent, le message de synchronisation courant contenant un identifiant incrémental de message de synchronisation et un instant temporel d'envoi du message de synchronisation précédent, chaque dispositif communicant (4, 10) récepteur desdits messages de synchronisation étant configuré pour mémoriser une table de synchronisation locale, mémorisant des informations relatives à des instants temporels, dans le référentiel temporel local, de réception de messages du dispositif de synchronisation et les instants temporels d'envoi desdits messages de synchronisation, dans le référentiel temporel de référence, par le dispositif de synchronisation.

7. Système selon la revendication 6, dans lequel chaque dispositif communicant (4, 10) est configuré pour calculer une correspondance entre l'horloge locale dudit dispositif communicant et l'horloge de référence en utilisant la table de synchronisation locale.

8. Système selon l'une des revendications 1 à 7, dans lequel le dispositif de synchronisation est un dispositif de communication passerelle (12), comportant une interface de communication (14) configurée pour communiquer selon ledit protocole de communication.

9. Procédé de calibration de mesures de tension mis en oeuvre dans un système de calibration conforme à l'une quelconque des revendications 1 à 8 comportant des étapes :
- par le dispositif de calibration (10):
- déterminer (64) un premier instant temporel de référence, dans le référentiel temporel de référence, d'un évènement de passage par zéro dudit signal de tension mesuré par le dispositif de calibration,
- émettre (66) un message de calibration comprenant ledit premier instant temporel de référence et une valeur d'amplitude de tension mesurée vers au moins un dispositif mesure grandeurs électriques (4)
- par au moins un dispositif de mesure de grandeurs électriques :
recevoir (74) ledit message de calibration en provenance du dispositif de calibration, et extraire ledit premier instant temporel de référence et l'amplitude de tension,
déterminer (76) un deuxième instant temporel de passage à zéro du signal de tension mesuré localement, dans le référentiel temporel de référence, dit deuxième instant temporel de référence, correspondant audit premier instant de référence,
calculer (78) un décalage de phase du signal de tension mesuré localement, en fonction de la différence entre le premier instant temporel de référence et le deuxième instant temporel de référence,
appliquer (80) une calibration de tension en phase et en amplitude en fonction de l'amplitude de tension reçue et du décalage de phase calculé.

10. Procédé selon la revendication 9, dans lequel ledit mécanisme de synchronisation comporte, par le dispositif de synchronisation, un envoi de messages de synchronisation successifs à au moins un dispositif communicant parmi les dispositifs de mesure de grandeurs électriques et le dispositif de calibration, les messages successifs comportant au moins un message de synchronisation courant et un message de synchronisation précédent, le message de synchronisation courant comprenant un identifiant incrémental de message de synchronisation et un instant temporel d'envoi du message précédent.

11. Procédé selon la revendication 10, dans lequel lesdits messages de calibration et de synchronisation sont envoyés par ledit dispositif de synchronisation, regroupés en des messages de calibration et synchronisation, à destination desdits dispositifs de mesure de grandeurs électriques.

## Patentansprüche

1. System zur Kalibrierung von Spannungsmessungen in einem Messsystem elektrischer Größen durch eine Vielzahl von Messvorrichtungen elektrischer Größen, die in einer elektrischen Anlage verteilt sind,
jede Messvorrichtung elektrischer Größen (4)umfassend
- ein Spannungsmessmodul (22) durch kapazitive Kopplung,
- eine Kommunikationsschnittstelle (20), die konfiguriert ist, um gemäß einem Kommunikationsprotokoll zu kommunizieren,
- eine lokale Uhr (26), die eine Datierung von Ereignissen in einem lokalen Zeitbezugssystem ermöglicht,
das System ferner umfassend eine einzelne Kalibrierungsvorrichtung (10), die konfiguriert ist, um durch Kontakt mit einem oder jedem elektrischen Leiter der elektrischen Anlage ein Spannungssignal zu messen (32), wobei die Kalibrierungsvorrichtung (10) eine Kommunikationsschnittstelle (30), die konfiguriert ist, um gemäß dem Kommunikationsprotokoll zu kommunizieren, und einen lokalen Zeitgeber (36) umfasst,
wobei das System **dadurch gekennzeichnet ist, dass** es ferner eine Synchronisationsvorrichtung umfasst, die einen sogenannten Synchronisationszeitgeber umfasst, der eine Datierung des Ereignisses in einem Referenzzeitbezugssystem ermöglicht,
wobei die Messvorrichtungen elektrischer Größen (4) und die Kalibrierungsvorrichtung (10) jeweils konfiguriert sind, um mit der Synchronisationsvorrichtung zu kommunizieren und einen Mechanismus zur Synchronisation des lokalen Zeitgebers mit dem Synchronisationszeitgeber zu implementieren, der eine Ereignisdatierung in dem Referenzzeitbezugssystem ermöglicht, und dadurch, dass:
die Kalibrierungsvorrichtung (10) zu Folgendem konfiguriert ist:
Bestimmen eines ersten Referenzzeitpunkts in dem Referenzzeitbezugssystem eines Nulldurchgangsereignisses des Spannungssignals, das von der Kalibrierungsvorrichtung gemessen wird,
Emittieren einer Kalibrierungsnachricht, die den ersten Referenzzeitpunkt und einen gemessenen Spannungsamplitudenwert umfasst, an mindestens eine Messvorrichtung elektrischer Größen (4) und,
wobei die mindestens eine Messvorrichtung elektrischer Größen (4) zu Folgendem konfiguriert ist:
Empfangen der Kalibrierungsnachricht von der Kalibrierungsvorrichtung und Extrahieren des ersten Referenzzeitpunkts und der Spannungsamplitude,
Bestimmen eines zweiten Nulldurchgangszeitpunkts des lokal gemessenen Spannungssignals in dem Referenzzeitbezugssystem, des sogenannten zweiten Referenzzeitpunkts, der dem ersten Referenzzeitpunkt entspricht,
Berechnen einer Phasenverschiebung des lokal gemessenen Spannungssignals abhängig von der Differenz zwischen dem ersten Referenzzeitpunkt und dem zweiten Referenzzeitpunkt,
Anwenden einer Spannungskalibrierung in Phase und Amplitude abhängig von der empfangenen Spannungsamplitude und der berechneten Phasenverschiebung.

2. System nach Anspruch 1, wobei die Messvorrichtung elektrischer Größen (4) konfiguriert ist, um eine Vielzahl von zweiten, in dem Referenzbezugssystem ausgedrückten Nulldurchgangszeitpunkten des lokal gemessenen Spannungssignals zu speichern.

3. System nach Anspruch 2, wobei zur Bestimmung des zweiten Referenzzeitpunkts die Messvorrichtung elektrischer Größen (4) konfiguriert ist, um unter den gespeicherten zweiten Zeitpunkten den zweiten Nulldurchgangszeitpunkt bestimmt, der dem ersten Referenzzeitpunkt am nächsten liegt.

4. System nach einem der Ansprüche 1 bis 3, wobei die Kalibrierungsvorrichtung (10) konfiguriert ist, um die Kalibrierungsnachricht an alle Messvorrichtungen elektrischer Größen auszusenden.

5. System nach einem der Ansprüche 1 bis 4, wobei das Kommunikationsprotokoll das ZigBee Green Power Protokoll ist.

6. System nach einem der Ansprüche 1 bis 5, wobei die Synchronisationsvorrichtung (12) konfiguriert ist, um nacheinander Synchronisationsnachrichten an mindestens eine kommunizierende Vorrichtung der Messvorrichtungen elektrischer Größen (4) und der Kalibrierungsvorrichtung (10) zu senden, wobei die aufeinanderfolgenden Synchronisationsnachrichten mindestens eine aktuelle Synchronisationsnachricht und eine vorherige Synchronisationsnachricht umfassen, wobei die aktuelle Synchronisationsnachricht eine inkrementale Kennung der Synchronisationsnachricht und einen Zeitpunkt des Sendens der vorherigen Synchronisationsnachricht enthält, jede kommunizierende Vorrichtung (4, 10), die die Synchronisationsnachrichten empfängt, konfiguriert ist, um eine lokale Synchronisationstabelle zu speichern, die Informationen über die Zeitpunkte in dem lokalen Zeitbezugssystem eines Empfangens von Nachrichten von der Synchronisationsvorrichtung und die Zeitpunkte des Sendens der Synchronisationsnachrichten in dem Referenzzeitbezugssystem durch die Synchronisationsvorrichtung speichert.

7. System nach Anspruch 6, wobei jede kommunizierende Vorrichtung (4, 10) konfiguriert ist, um eine Übereinstimmung zwischen der lokalen Zeit des kommunizierenden Vorrichtung und der Referenzzeit unter Verwendung der lokalen Synchronisationstabelle zu berechnen.

8. System nach einem der Ansprüche 1 bis 7, wobei die Synchronisationsvorrichtung eine Gateway-Kommunikationsvorrichtung (12) ist, umfassend eine Kommunikationsschnittstelle (14), die konfiguriert ist, um gemäß dem Kommunikationsprotokoll zu kommunizieren.

9. Kalibrierungsverfahren für Spannungsmessungen, das in einem Kalibriersystem nach einem der Ansprüche 1 bis 8 durchgeführt wird, umfassend die folgenden Schritte:
- durch die Kalibrierungsvorrichtung (10):
- Bestimmen (64) eines ersten Referenzzeitpunkts in dem Referenzzeitbezugssystem eines Nulldurchgangsereignisses des Spannungssignals, das von der Kalibrierungsvorrichtung gemessen wird,
- Senden (66) einer Kalibrierungsnachricht, die den ersten Referenzzeitpunkt und einen gemessenen Spannungsamplitudenwert umfasst, an mindestens eine Messvorrichtung elektrischer Größen (4)
- durch mindestens eine Messvorrichtung elektrischer Größen:
Empfangen (74) der Kalibrierungsnachricht von der Kalibrierungsvorrichtung und Extrahieren des ersten Referenzzeitpunkts und der Spannungsamplitude,
Bestimmen (76) eines zweiten Nulldurchgangszeitpunkts des lokal gemessenen Spannungssignals in dem Referenzzeitbezugssystem, des sogenannten zweiten Referenzzeitpunkts, der dem ersten Referenzzeitpunkt entspricht,
Berechnen (78) einer Phasenverschiebung des lokal gemessenen Spannungssignals abhängig von der Differenz zwischen dem ersten Referenzzeitpunkt und dem zweiten Referenzzeitpunkt,
Anwenden (80) einer Spannungskalibrierung in Phase und Amplitude abhängig von der empfangenen Spannungsamplitude und der berechneten Phasenverschiebung.

10. Verfahren nach Anspruch 9, wobei der Synchronisationsmechanismus durch die Synchronisationsvorrichtung ein Senden von aufeinanderfolgenden Synchronisationsnachrichten an mindestens eine kommunizierende Vorrichtung der Messvorrichtungen elektrischer Größen und der Kalibrierungsvorrichtung umfasst, wobei die aufeinanderfolgenden Nachrichten mindestens eine aktuelle Synchronisationsnachricht und eine vorherige Synchronisationsnachricht umfassen, wobei die aktuelle Synchronisationsnachricht eine inkrementale Kennung der Synchronisationsnachricht und einen Zeitpunkt des Sendens der vorherigen Nachricht umfasst.

11. Verfahren nach Anspruch 10, bei dem die Kalibrierungs- und Synchronisationsnachrichten von der Synchronisationsvorrichtung, zusammengefasst in Kalibrierungs- und Synchronisationsnachrichten, an die Messvorrichtungen elektrischer Größen gesendet werden.

## Claims

1. A system for calibrating voltage measurements in a system for measuring electrical quantities using a plurality of devices for measuring electrical quantities distributed within an electrical installation,
each device for measuring electrical quantities (4)comprising
- a capacitive voltage measurement module (22),
- a communication interface (20) configured to communicate according to a communication protocol,
- a local clock (26) for dating events in a local time reference frame,
the system further comprising a single calibration device (10), configured to measure (32) a voltage signal by contact with one or each electrical conductor of the electrical installation, the calibration device (10) comprising a communication interface (30) configured to communicate according to said communication protocol and a local clock (36),
the system being **characterised in that** it further comprises a synchronisation device comprising a synchronisation clock, enabling an event to be dated within a reference time frame,
said devices for measuring electrical quantities (4) and the calibration device (10) each being configured to communicate with the synchronisation device and to implement a mechanism for synchronising the local clock with the synchronisation clock, enabling an event to be dated within a reference time frame, and **in that**:
the calibration device (10) is configured to:
determine a first reference time instant, in the reference time frame, of a zero-crossing event of said voltage signal measured by the calibration device,
transmit a calibration message comprising said first reference time instant and a measured voltage amplitude value to at least one electrical quantity measuring device (4) and,
said at least one device for measuring electrical quantities (4) is configured to:
receive said calibration message from the calibration device, and extract said first reference time instant and the voltage amplitude,
determine a second zero-crossing time instant of the locally measured voltage signal, within the reference time frame, known as the second reference time instant, corresponding to said first reference time instant,
calculate a phase shift of the locally measured voltage signal as a function of the difference between the first reference time instant and the second reference time instant,
apply a voltage calibration in phase and amplitude as a function of the voltage amplitude received and the phase offset calculated.

2. The system according to claim 1, wherein said device for measuring electrical quantities (4) is configured to store a plurality of second zero-crossing time instants, expressed in the reference frame, of the locally measured voltage signal.

3. The system according to claim 2, wherein, in order to determine the second reference time instant, said device for measuring electrical quantities (4) is configured to determine, from among the stored second time instants, the second zero-crossing time instant closest to said first reference time instant.

4. The system according to one of claims 1 to 3 wherein said calibration device (10) is configured to broadcast said calibration message to all the devices for measuring electrical quantities.

5. The system according to one of claims 1 to 4, wherein said communication protocol is the ZigBee Green Power protocol.

6. The system according to any one of claims 1 to 5, wherein the synchronisation device (12) is configured to successively send synchronisation messages to at least one communicating device among the devices for measuring electrical quantities (4) and said calibration device (10), the successive synchronisation messages comprising at least one current synchronisation message and one previous synchronisation message, the current synchronisation message containing an incremental synchronisation message identifier and a time instant when the previous synchronisation message was sent, each communicating device (4, 10) receiving said synchronisation messages being configured to store a local synchronisation table, storing information relating to time instants, in the local time reference frame, when the messages are received from the synchronisation device and the time instants when said synchronisation messages are sent, within the time reference frame, by the synchronisation device.

7. The system according to claim 6, wherein each communicating device (4, 10) is configured to calculate a match between the local clock of said communicating device and the reference clock using the local synchronisation table.

8. The system according to one of claims 1 to 7, wherein the synchronisation device is a gateway communication device (12), comprising a communication interface (14) configured to communicate according to said communication protocol.

9. A method for calibrating voltage measurements implemented in a calibration system conforming to any one of claims 1 to 8, comprising the steps:
- by the calibration device (10):
- determining (64) a first reference time instant, in the reference time frame, of a zero-crossing event of said voltage signal measured by the calibration device,
- sending (66) a calibration message comprising said first reference time instant and a measured voltage amplitude value to at least one device for measuring electrical quantities (4)
- by at least one device for measuring electrical quantities:
receiving (74) said calibration message from the calibration device, and extracting said first reference time instant and the voltage amplitude,
determining (76) a second zero-crossing time instant of the locally measured voltage signal, in the reference time frame, known as the second reference time instant, corresponding to said first reference time instant,
calculating (78) a phase shift of the locally measured voltage signal as a function of the difference between the first reference time instant and the second reference time instant,
applying (80) a voltage calibration in phase and amplitude as a function of the received voltage amplitude and the calculated phase shift.

10. The method according to claim 9, wherein said synchronization mechanism comprises the synchronization device sending successive synchronization messages to at least one communicating device among the devices for measuring electrical quantities and the calibration device, the successive messages comprising at least one current synchronization message and one previous synchronization message, the current synchronization message comprising an incremental synchronization message identifier and a time instant at which the previous message was sent.

11. The method according to claim 10, wherein said calibration and synchronisation messages are sent by said synchronisation device, grouped together in calibration and synchronisation messages, to said devices for measuring electrical quantities.
